**Europäisches Patentamt**

**European Patent Office**

**Office européen des brevets**

(19)

(11) Veröffentlichungsnummer: **0 104 580**

**B1**

(12)

# EUROPÄISCHE PATENTSCHRIFT

(45) Veröffentlichungstag der Patentschrift:
**02.09.87**

(21) Anmeldenummer: **83109273.9**

(22) Anmeldetag: **19.09.83**

(51) Int. Cl.⁴: **H 01 C 1/142,** H 01 G 1/14,
H 01 C 17/24, H 01 G 4/24

(54) **Verfahren zur Herstellung elektrischer Chip-Bauelemente.**

(30) Priorität: **21.09.82 DE 3234895**

(43) Veröffentlichungstag der Anmeldung:
**04.04.84 Patentblatt 84/14**

(45) Bekanntmachung des Hinweises auf die Patenterteilung:
**02.09.87 Patentblatt 87/36**

(84) Benannte Vertragsstaaten:
**AT BE CH DE FR GB IT LI NL SE**

(56) Entgegenhaltungen:
**WO-A-81/00786**
**GB-A-1 089 925**

**ELECTRONICS, Band 43, Nr. 8, 13. April 1970, Seite 185, New York, USA; "Step-repeat unit trims resistors"**

(73) Patentinhaber: **Siemens Aktiengesellschaft Berlin und München, Wittelsbacherplatz 2, D-8000 München 2 (DE)**

(72) Erfinder: **Zitzler, Rudolf, Dipl.- Ing., Lottnerstrasse 3, D-8400 Regensburg (DE)**
Erfinder: **Sonnenberg, Michael, Alfons- Bayerer-Strasse 9, D-8400 Regensburg (DE)**

EP 0 104 580 B1

## Beschreibung

Die Erfindung betrifft ein Verfahren zur Herstellung elektrischer Chip-Bauelemente, wie elektrischer Widerstand, Kondensator und Halbleiter, mit plättchenförmigem Substrat, auf dessen eine Substratseite elektrisch aktive Schichten aufgebracht sind, die mit mindestens auf die Substratgegenseite aufgebrachten Kontaktschichten galvanisch verbunden sind.

Soweit bereits elektrische Chip-Bauelemente der genannten Art bekannt geworden sind, erfolgt die Durchkontaktierung, d.h. die galvanische Verbindung zwischen den Kontaktflächen der beiden Substratseiten mittels Bohrlöcher, die mit elektrisch leitendem Material, insbesondere Lot gefüllt sind oder - wie dies z. B. durch die WO-A-81/00786 bekannt geworden ist - durch Leiterbahnen, die randoffene Kerben der Substrat-Stirnseiten auskleiden und so die Kontaktschichten miteinander verbinden.

Zur Fertigung elektrischer Kondensatoren mit Glimmer als Dielektrikum, schlägt beispielsweise die GB-A-1089925 vor, ein beidseitig metallisiertes rechteckförmiges Glimmerplättchen mit in Reihen und in geeignetem Abstand zueinander ausgerichteten sowie in ihren Wandflächen metallisierten Bohrungen auszubilden, wonach das Glimmerplättchen teils unter Auftrennung längs dieser Reihen von Bohrungen in kleinere Plättchen jeweils gleicher Größe unterteilt und diese unter entsprechender Ausrichtung der metallisierten Bohrungen gestapelt werden, derart, daß nach Auffüllen der Bohrungen mit Metall Kondensatoren mit Elektroden und Kontakten entstehen.

Der vorliegenden Erfindung liegt die Aufgabe zugrunde, ein Verfahren zur Herstellung elektrischer Chip-Bauelemente der eingangs genannten Art anzugeben, das geeignet ist, Chip-Bauelemente mit nur geringem Aufwand in großen Stückzahlen zu fertigen.

Zur Lösung dieser Aufgabe sieht die Erfindung vor, daß ein zur Auftrennung in eine Vielzahl rechteckförmiger Chip-Bauelemente bestimmter Chip im Rastermaß der Chip-Bauelemente mit Bohrlochreihen versehen wird, daß auf die eine Substratseite des Chips eine gemeinsame elektrisch leitende Schicht aufgebracht wird, daß längs der Bohrlochreihen elektrische Kontaktschichten auf die elektrisch leitende Schicht und auf die unbeschichtete Substratgegenseite sowie auf die Mantelflächen der Bohrlöcher aufgebracht werden, daß die kontaktierte elektrisch leitende Schicht des Chips mittels Laser im Rastermaß der Chip-Bauelemente in die elektrisch aktiven Schichten der einzelnen Chip-Bauelemente zerteilt wird, derart, daß die Bohrlochreihen mittig aufgetrennt werden, und daß der Chip in seine Chip-Bauelemente vereinzelt wird.

Die Fertigung bereits mit Bohrlochreihen ausgerüsteter Chips bereitet keine Schwierigkeiten. Auch entfallen gesonderte Arbeitsschritte zur "Durchkontaktierung", d.h. zur galvanischen Verbindung der Kontaktschichten auf beiden Substratseiten.

Die Erfindung wird nachstehend anhand eines Ausführungsbeispiels näher erläutert.

Es zeigt:

Fig. 1 ein gemäß dem Verfahren nach der Erfindung gefertigtes Chip-Bauelement in perspektivischer und schematischer Darstellung,

Fig. 2 einen Chip mit Chip-Bauelementen gemäß Fig. 1 in Draufsicht.

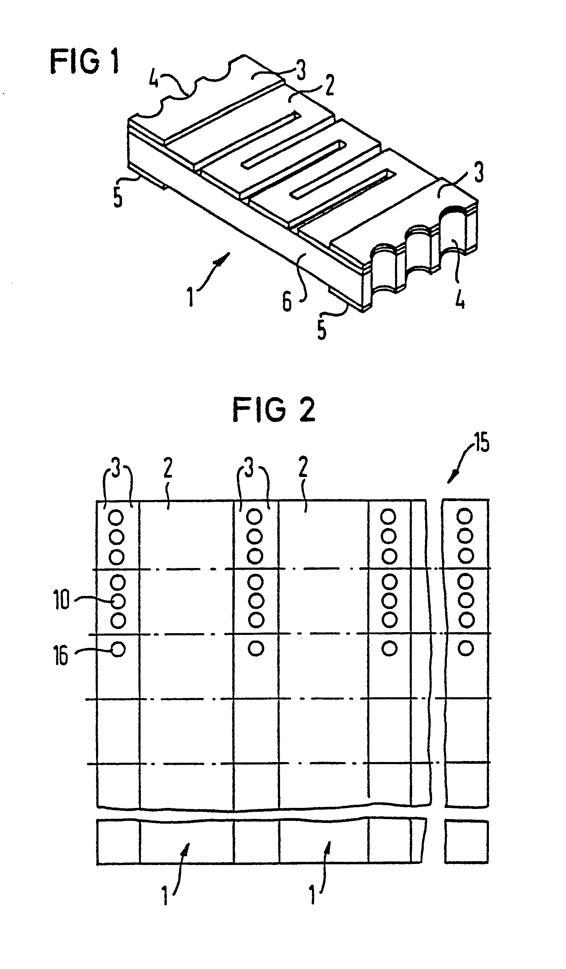

Das in Fig. 1 dargestellte Chip-Bauelement 1 zeigt einen elektrischen Widerstand in Chip-Bauweise mit einem $Al_2O_3$-Substrat 6 als Träger der elektrisch aktiven, mittels Laserstrahls abgeglichenen Widerstandsschicht 2. Die beidseitig unmittelbar auf das Substrat bzw. auf die Widerstandsschicht 2 aufgebrachten elektrischen Kontatkschichten 3, 5 sind über randoffene Ausnehmungen 4, deren Mantelflächen mit elektrisch leitenden Schichten bedeckt sind, miteinander galvanisch verbunden. Im gezeigten Ausführungsbeispiel besitzen die Ausnehmungen 4 halbkreisscheibenförmigen Querschnitt. Möglich ist auch und zwar insbesondere bei relativ kleinem Querschnitt der Ausnehmungen 4, daß die Ausnehmungen mit elektrisch leitfähigem Material gefüllt sind

Zur Massenfertigung, z. B. der in Figur 1 gezeigten Bauelemente, werden Chips 15 gemäß Fig. 2, z. B. $Al_2O_3$-Substrate, verwendet, die zur späteren Auftrennung und Vereinzelung in eine Vielzahl rechteckförmiger Chip-Bauelemente 1 bereits im Rastermaß dieser Chip-Bauelemente mit Bohrlochreihen 10 versehen sind. Eine der beiden Substratseiten wird zunächst mit einer verhältnismäßig gleichmäßigen Flächenwiderstandsschicht 2 bedeckt, wodurch das Ausmessen und Aussortieren der einzelnen Chips 15 entfallen kann. Z.B. Mittels Siebdruck werden in einem weiteren Arbeitsgang längs der Bohrlochreihen 10 elektrische Kontaktschichten 3 bzw. 5 auf die Flächenwiderstandsschicht und auf die schichtfreie Substratgegenstite des Chips 15 sowie auf die Mantelflächen der Bohrlöcher 16 aufgebracht. Anschließend wird der beschichtete und kontaktiertte Chip mittels Lasers auf das Chipmaß geritzt, d.h. die elektrisch aktive Schicht und die Kontaktschichten werden im Rastermaß der Chip-Bauelemente 1 in die einzelnen Chip-Bauelemente zerteilt, derart, daß die Bohrlochreihen 10 mittig aufgetrennt werden. Dadurch ist sowohl das geometrische Maß der Einzelchips als auch der Ausgangswert des Flächenwiderstands jedes einzelnen abzugleichenden Chip-Bauelements festgelegt. Vorausgesetzt, ein Abgleich der Ausgangswerte der Widerstände der einzelnen Chip-Bauelemente wäre nicht erforderlich, so könnte bereits jetzt der Chip in seine einzelnen Chip-Bauelemente 1 vereinzelt werden; was üblicherweise durch Ausbrechen der einzelnen Chip-Bauelemente aus der Substratplatte erfolgt. Üblicherweise ist jedoch ein Abgleich der Ausgangswerte der Widerstände erforderlich, der vorteilhafterweise mittels eines mit einer Meßeinrichtung gekoppelten Laserstrahls erfolgt. Zu diesem Zweck wird der mittels Laserstrahls in seine einzelnen Chip-Bauelemente 1 aufgetrennte, kontaktierte Chip 15 mit seiner unbeschichteten, jedoch kontaktierten Substratgegenseite auf eine im Rastermaß des Chips mit Kontaktstreifen bedeckte, in der Zeichnung nicht dargestellte Positionierplatte aufgelegt und schrittweise je Widerstandsschicht 2 jedes einzelnen Chip-Bauelements 1 der Abgleich durchgeführt. Durch die gewählte Art der Kontaktierung ist eine kontaktsichere Auflage der Kontakschichen 5 auf den entsprechenden Kontaktschichten der Positionierplatte gewährleistet und damit ein sicherer Abgleich, der über eine an die Kontaktschichten der Positionierplatte angeschaltete Meßeinrichtung erfolgt, die den Laserstrahl hinsichtlich seiner Bewegung und ggf. auch Intensität steuert.

Im Anschluß an den vorstehend erläuterten Abgleich werden die Kontaktschichten 3 abgedeckt, die Chips 15 zu einer Vielzahl von Chips zusammengefaßt und ihre abgeglichenen, elektrisch aktiven Schichten 2 in einem gemeinsamen Arbeitsgang mit einer Schutzschicht bedeck, wonach die Abdeckungen der einzelnen Kontaktschichtten 3 entfernt und die an sich fertigen, einzelnen Chip-Bauelemente 1 durch erneute Auflage der Chips 15 auf die Positionierplatten auf ihre Endwerte geprüft werden.

Zweckmäßigeweise werden dabei die ermittelten Endwerte der einzelnen Chip-Bauelemente gespeichert und, gesteuert durch den Speicher, lediglich die Chip-Bauelemente mit ihren jeweils ermittelten elektrischen Werten ausgezeichnet, d.h. gestempelt, die den geforderten Werten entsprechen. Ungestempelte Chip-Bauelemente, d.h. also unbrauchbare Bauelemente, können so bei der abschließenden Vereinzelung, die durch Ausbrechen der einzelnen Chip-Bauelemente aus der Substratplatte erfolgt, mühelos ausgeschieden werden.

Durch das vorstehend erläuterte Verfahren erübringt sich die bischer angewendete Rundum-Kontaktierung, wodurch die Vereinzelung des Chips bzw. der Substratplatte in die einzelnen Chip-Bauelemente an der Schluß der Herstellungsverfahrens verlegt werden kann. Die Vorteile dieser, an das Herstellungsende verlagerten Vereinzelung sind offensichtlich. Es kann nicht nur eine Vierzahl von Chip-Bauelementen gleichzeitig bearbeitet werden; es scheiden auch fertigungstechnische Unsicherheiten aus, wie sie beispielsweise bei Fertigungsverfahren auftreten, die auf der Grundlage von Einzelchips und zu Streifen zusammengefaßten Einzelchips beruhen. Wie Fig. 1 zeigt, sind die stirnseitigen Ausnehmungen der Substrate i.ü. zusätzlich als Führungselemente beim Magazinieren der Chip-Bauelemente geeignet.

## Patentansprüche

1. Verfahren zur Herstellung elektrischer Chip-Bauelemente wie elektrischer Widerstand, Kondensator und Halbleiter, mit plättchenförmigem Substrat, auf dessen eine Substratseite elektrisch aktive Schichten aufgebracht sind, die mit mindestens auf die Substratgegenseite aufgebrachten Kontaktschichten galvanisch verbunden sind, dadurch gekennzeichnet , daß ein zur Auftrennung in eine Vielzahl rechteckförmiger Chip-Bauelemente (1) bestimmter Chip (15) im Rastermaß der Chip-Bauelemente mit Bohrlochreihen (10) versehen wird, daß auf die eine Substratseite des Chips eine gemeinsame elektrisch leitende Schicht aufgebracht wird, daß längs der Bohrlochreihen (10) elektrische Kontaktschichten (3 bzw. 5) auf die elektrisch leitende Schicht und auf die unbeschichtete Substratgegenseite sowie auf die Mantelflächen der Bohrlöcher (16) aufgebracht werden, daß die kontaktierte elektrisch leitende Schicht des Chips mittels Lasers im Rastermaß der Chip-Bauelemente (1) in die elektrisch aktiven Schichten (2) der einzelnen Chip-Bauelemente zerteilt wird, derart, daß die Bohrlochreihen (10) mittig aufgetrennt werden, und daß der Chip in seine Chip-Bauelemente (1) vereinzelt wird.

2. Verfahren nach Anspruch 1, dadurch gekennzeichnet, daß der mittels Lasers in die elektrisch aktiven Schichten (2) der einzelnen Chip-Bauelemente (1) zerteilte, kontaktierte Chip (15) mit seiner unbeschichteten, jedoch kontaktierten Substratgegenseite auf eine im Rastermaß des Chips mit Kontaktstreifen bedeckte, mit einem Laser samt Meßeinrichtung gekoppelte Positionierplatte deckungsgleich aufgelegt wird, und daß die elektrisch aktiven Schichten (2) der einzelnen Chip-Bauelemente (1) schrittweise abgeglichen werden.

3. Verfahren nach Anspruch 1 und 2, dadurch gekennzeichnet, daß im Anschluß an den Abgleich der elektrisch aktiven Schichten (2) die Kontaktschichten (3) der elektrisch aktiven Schichten (2) abgedeckt, die Chips (15) zu einer Vielzahl von Chips zusammengefaßt und ihre abgeglichenen, elektrisch aktiven Schichten (2) in einem gemeinsamen Arbeitsgang mit einer Schutzschicht bedeckt werden, wonach die Abdeckungen der Kontaktschichten (3) entfernt und die einzelnen Chip-Bauelemente (1) durch erneute Auflage der Chips auf die Positionierplatten auf ihre Endwerte geprüft werden.

## Claims

1. A process for the production of electrical chip components, such as electrical resistors, capacitors and semiconductors, which comprise a plate-like substrate to one side of which electrically active layers are applied which are electrically connected to contact layers applied at least to the other side of the substrate, characterised in that a chip (15), which is to be divided into a plurality of rectangular chip components (1), is provided with rows of drill holes (10) at the grid dimensions of the chip components; that a common, electrically conductive layer is applied to the one substrate side of the chip;

that along the rows of drill holes (10), electrical contact layers (3 and 5) are applied to the electrically conductive layer and to the uncoated other side of the substrate and also to the generated surfaces of the drill holes (16);

that the contacted, electrically conductive layer of the chip is divided by means of a laser in the grid dimensions of the chip components (1), into the electrically active layers (2) of the individual chip components, in such manner that the rows of drill holes (10) are axially divided;

and that the chip is separated into its chip components (1).

2. A process as claimed in Claim 1, characterised in that the contacted chip (15), which has been divided by means of the laser into the electrically active layers (2) of the individual chip components (1), is positioned with its uncoated but contacted other substrate side against a positioning plate so as to coincide therewith, said plate being covered with contact strips in the grid dimensions of the chip and coupled to a laser and to a measuring device; and that the electrically active layers (2) of the individual chip components (1) are adjusted step-by-step.

3. A process as claimed in Claim 1 and 2, characterised in that after the adjustment of the electrically active layers (2), the contact layers (3) of the electrically active layers (2) are covered, the chips (15) are assembled to form a plurality of chips, and their adjusted, electrically active layers (2) are covered with a protective layer in a common operation, whereupon the covering of the contact layers (3) is removed and the individual chip components (1) are checked with respect to their final values by re-applying the chips to the positioning plates.

**Revendications**

1. Procédé pour la fabrication de composants électriques en forme de puces, constituant une résistance, un condensateur ou un semiconducteur par exemple, avec un substrat en forme de plaquette, substrat sur un côté duquel sont appliquées des couches électriques actives qui sont reliées galvaniquement à des couches de contact disposées au moins sur le côté opposé du substrat, caractérisé en ce qu'il comprend le perçage de rangées de trous (10) dans une puce (15), en vue de son partage en un grand nombre de composants rectangulaires en forme de puces (1), le perçge étant réalisé suivant la grille de base des composants en forme de puces, l'application d'une couche commune électriquement conductrice sur un côté du substrat de la puce, l'application, le long des rangées de trous percés (10), de couches de contact électriques (3 respectivement 5) sur la couche électriquement conductrice et sur le côté opposé, non revêtu, du substrat, de même que sur les surfaces latérales des trous percés (16), la division par laser de la couche électriquement conductrice de la puce, couche qui a été pourvue de contacts, la division étant effectuée suivant la grille de base des composants en forme de puces (1) et délimitant les couches électriquement actives (2) des composants en forme de puces individuels, de manière que les rangées de trous percés (10) soient partagées au milieu, et la séparation de la puce en ses composants individuels en forme de puces (1).

2. Procédé selon la revendication 1, caractérisé en ce que la puce (15), munie de contacts et divisée par laser en couches électriques actives (2) pour les composants individuels en forme de puces (1), est disposée à recouvrement, par son côté opposé du substrat, côté qui n'est pas revêtu mais qui est muni de contacts, sur une plaque de positionnement, laquelle est recouverte de bandes de contact suivant la grille de base de la puce et est couplée à un laser combiné avec un dispositif de mesure, et que les couches électriques actives (2) des composants individuels en forme de puces (1) sont égalisées pas à pas.

3. Procédé selon les revendications 1 et 2, caractérisé en ce que, à la suite de l'égalisation des couches électriques actives (2), les couches de contact (3) des couches électriques actives (2) sont recouvertes, les puces (15) sont assemblées en un grand nombre de puces et leurs couches électriques actives (2), égalisées, sont recouvertes d'une couche de protection dans une opération collective, à la suite de laquelle les recouvrements des couches de contact (3) sont enlevés et les valeurs finales des composants individuels en forme de puces (1) sont contrôlées par une nouvelle disposition des puces sur les plaques de positionnement.

# FIG 1

4  3  2

5  1  6  5  4  3

# FIG 2

3  2  3  2  15

10

16

1  1